# FASCICULE DE BREVET EUROPEEN

(11) **EP 1 854 210 B1**
(45) Date de publication et mention de la délivrance du brevet: **31.07.2019**
(21) Numéro de dépôt: 06709521.6
(22) Date de dépôt: 16.02.2006
(51) Int. Cl.: H03H 3/04, H03H 9/17, H03H 9/02

(54) **DISPOSITIF A ONDES ACOUSTIQUES HAUTE FREQUENCE**
HOCHFREQUENZ-AKUSTIKWELLENBAUELEMENT
HIGH-FREQUENCY ACOUSTIC WAVE DEVICE

(30) Priorité: 16.02.2005 FR 0550442
(43) Date de publication de la demande: 14.11.2007
(73) Titulaire: CENTRE NATIONAL DE LA RECHERCHE SCIENTIFIQUE -CNRS-, 75794 Paris Cedex 16 (FR); UNIVERSITE DE FRANCHE-COMTE, 250030 Besançon Cedex (FR)
(72) Inventeur: KHELIF, Abdelkrim, F-25000 Besancon (FR); CHOUJAA, Abdelkrim, F-25770 Serre Les Sapins (FR); LAUDE, Vincent, F-25870 Devecey (FR)
(74) Mandataire: Lavoix
(86) Numéro de dépôt international: PCT/FR2006/050142
(87) Numéro de publication internationale: WO 2006/087496

(56) Documents cités:
- US-A- 4 427 913
- IRBY J H ET AL: "CALCULATION OF DELTAN2 AND KAPPA FOR AN ACOUSTICALLY INDUCED DISTRIBUTION BRAGG REFLECTOR (ADBR)" IEEE JOURNAL OF QUANTUM ELECTRONICS, IEEE INC. NEW YORK, US, vol. 34, no. 2, février 1998 (1998-02), pages 213-224, XP000737230 ISSN: 0018-9197
- BROWNING T I ET AL: "NEW FAMILY OF BULK-ACOUSTIC-WAVE DEVICES EMPLOYING INTERDIGITAL TRANSDUCERS" ELECTRONICS LETTERS, IEE STEVENAGE, GB, vol. 25, no. SPECIAL, 22 novembre 1989 (1989-11-22), pages S21-23, XP000105247 ISSN: 0013-5194
- BRIA D. ET AL: "Omnidirectional elastic band gap in finite lamellar structures", PHYSICAL REVIEW E. STATISTICAL PHYSICS, PLASMAS, FLUIDS, AND RELATED INTERDISCIPLINARY TOPICS, AMERICAN INSTITUTE OF PHYSICS, NEW YORK, NY, US, vol. 66, no. 5, 2002, pages 56609-1-56609-8, XP007903785,

## Description

### Domaine de l'invention

La présente invention concerne le domaine des dispositifs à propagation d'ondes acoustiques principalement utilisés dans le domaine de l'électronique pour constituer des systèmes résonants, des filtres, des lignes à retard, etc.

De tels dispositifs sont notamment utilisés dans le domaine des hautes fréquences, couramment jusqu'à quelques gigahertz et trouvent des applications notamment dans le domaine des transmissions, de la télévision, des téléphones portables, des capteurs et des étiquettes de marquage de produits.

### Exposé de l'art antérieur

On distingue deux types principaux de dispositifs à ondes acoustiques : les dispositifs à ondes acoustiques de surface (SAW) et les dispositifs à ondes acoustiques de volume (BAW) .

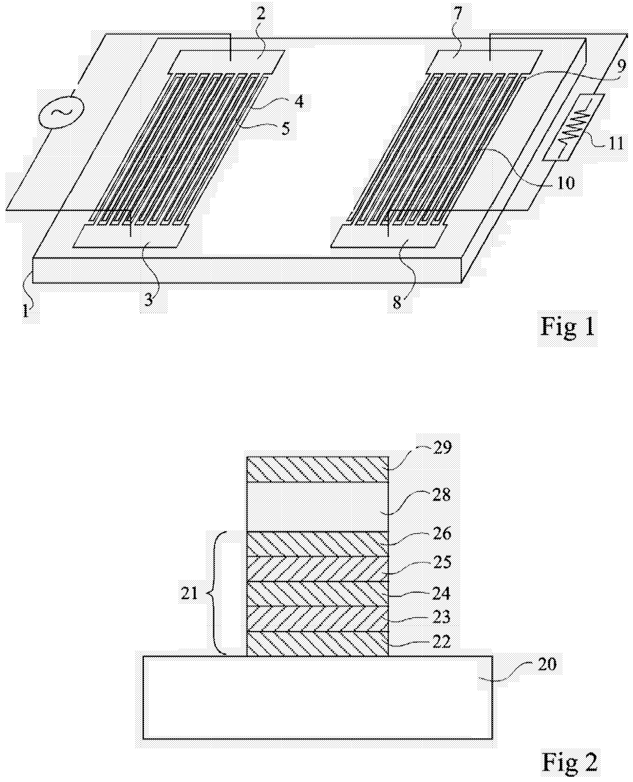

La figure 1 représente un exemple de dispositif classique à ondes acoustiques de surface constituant une ligne à retard. Ce dispositif est formé sur un substrat piézoélectrique 1, éventuellement une ou plusieurs couches minces piézoélectriques formées sur un substrat plus épais. Les ondes acoustiques sont émises dans le substrat à partir de deux peignes interdigités 2 et 3 comprenant des doigts conducteurs respectifs 4 et 5. Si on applique un signal variable en fonction du temps ou alternatif entre les peignes 2 et 3, ce signal est transformé par effet piézoélectrique en une onde acoustique de surface qui se propage dans le substrat 1. L'onde acoustique se propageant dans le substrat est recueillie par un ensemble de deux peignes récepteurs interdigités 7 et 8 comprenant des doigts métalliques respectifs 9 et 10 avec un retard correspondant au trajet parcouru par l'onde. Le signal est par exemple recueilli aux bornes d'une impédance électrique 11.

Ces dispositifs à ondes acoustiques de surface sont bien adaptés à la réalisation de composants à haute fréquence tels que mentionnés ci-dessus (lignes à retard, filtres, résonateurs, etc.). Ils permettent même de réaliser des filtres relativement complexes.

Toutefois, ces dispositifs posent des problèmes de réalisation pratique quand leur fréquence de fonctionnement augmente. En effet, le pas P des dents des peignes 2-3 et 7-8 détermine la longueur d'onde λ de l'onde acoustique par la relation P = λ/N, avec N ≥ 2, généralement égal à 2. Dans les matériaux couramment utilisés, la vitesse de propagation V des ondes de surface est de l'ordre de 5000 m/s. Pour une fréquence f de 2,5 GHz, par exemple, la longueur d'onde est de 2 µm (λ=V/f), c'est-à-dire que le pas des dents des peignes doit être de l'ordre de 1 pm. Ceci conduit à avoir des doigts métalliques d'une largeur de l'ordre de 0,5 µm espacés d'une distance de 0,5 pm. Il est en pratique difficile de miniaturiser davantage les peignes conducteurs d'une part pour des raisons de lithographie et d'autre part pour des raisons de pertes électriques. Les dispositifs à ondes acoustiques de surface sont donc en pratique limités à des fréquences de fonctionnement de l'ordre de 1 à 3 GHz.

Un autre type de dispositif à ondes acoustiques exploite les propriétés des ondes acoustiques de volume. De façon générale, quand le milieu de propagation est une couche mince, on exploite les ondes de volume dans l'épaisseur de la couche mince. Dans ce but, les électrodes sont placées de part et d'autre de cette couche mince. Ces dispositifs peuvent fonctionner à des fréquences supérieures à 3 GHz mais sont souvent délicats à élaborer, notamment en cas d'utilisation de membranes.

On notera en particulier le brevet des Etats-Unis d'Amérique N° 5873154 de la société Nokia Mobile Phones Limited, qui décrit une structure particulière de dispositifs à ondes acoustiques de volume. La figure 2 ci-jointe, reprend la figure 3 de ce brevet. On y trouve sur un substrat 20, par exemple en verre, un multicouche 21 constituant un miroir acoustique fondé sur le principe de Bragg et comportant des couches alternées 22 à 26, la couche supérieure 26 étant une couche conductrice. Une couche piézoélectrique 28 est formée au-dessus du miroir acoustique et est revêtue d'une électrode 29, de façon à pouvoir être excitée en résonance entre les électrodes 26 et 29. Dans cette structure, le miroir acoustique 21 est destiné à éviter que les vibrations produites dans la couche piézoélectrique 28 se répercutent dans le substrat 20. Les ondes formées dans la couche piézoélectrique 28 sont des ondes de volume classiques, et la figure 4 de ce brevet indique que les vitesses de propagation sont de l'ordre de 6000 m/s pour les ondes longitudinales et de 2720 m/s pour les ondes de cisaillement. Ainsi, dans ce dispositif, le miroir acoustique 21 n'est pas destiné à modifier les caractéristiques des ondes de volume apparaissant dans la couche piézoélectrique 28 mais seulement à assurer un isolement pour les vibrations entre la couche piézoélectrique 28 et le substrat 20.

Le brevet US 4 427 913 décrit un diffractomètre acoustique.

### Résumé de l'invention

Un objet de la présente invention est de prévoir un dispositif à ondes acoustiques permettant les nombreuses applications des dispositifs à ondes acoustiques de surface existants sans leurs inconvénients.

Un objet plus particulier de la présente invention est de prévoir un dispositif à ondes acoustiques susceptible de fonctionner à très haute fréquence.

Un autre objet de la présente invention est de prévoir un dispositif à ondes acoustiques excitable simplement par des structures superficielles à peignes de doigts conducteurs imbriqués, par exemple du type de ceux utilisés classiquement dans les filtres à ondes acoustiques de surface.

Pour atteindre ces objets, la présente invention prévoit un dispositif à ondes acoustiques tel que définit dans la revendication indépendante 1.

La présente invention prévoit d'utiliser le dispositif susmentionné, notamment comme filtre, comme résonateur ou comme ligne à retard.

La présente invention prévoit aussi un procédé de détermination d'un dispositif à ondes acoustiques tel que définit par la revendication indépendante 5, comprenant les étapes suivantes :
pour un couple donné de matériaux constituant le miroir acoustique sur un substrat donné, calculer les courbes de dispersion et choisir la valeur D de la somme des épaisseurs d'une couche de chaque matériau du couple de matériaux de sorte qu'un empilement du couple de matériaux constitue un miroir omnidirectionnel ayant une bande interdite dans une bande de fréquence souhaitée ; et
choisir l'épaisseur de la couche piézoélectrique pour que le miroir reste omnidirectionnel et que la couche piézoélectrique ait un mode de vibrations acoustiques dans la plage de fréquences interdites du miroir.

### Brève description des dessins

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 est une vue en perspective schématique d'une ligne à retard à ondes acoustiques de surface ;
la figure 2 est une vue en coupe d'un dispositif à ondes acoustiques de volume isolé par rapport au substrat, tel que décrit dans le brevet américain 5873154 ;
la figure 3 représente une structure de dispositif à ondes acoustiques selon la présente invention ; et
la figure 4 représente des courbes de dispersion caractéristiques d'une structure selon la présente invention.

### Description détaillée

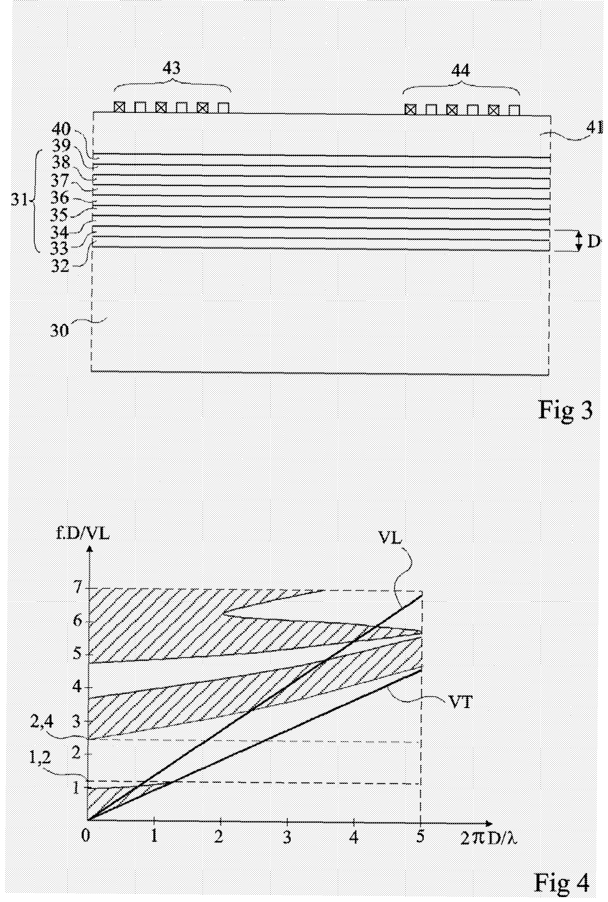

La figure 3 représente un mode de réalisation d'un dispositif à ondes acoustiques selon la présente invention. Ce dispositif comprend un substrat 30 surmonté d'un miroir acoustique 31 constitué d'un ensemble de couches 32 à 40, les couches de référence paire étant d'un premier matériau et les couches de référence impaire étant d'un deuxième matériau, ces deux matériaux ayant des impédances acoustiques nettement différentes. On pourra par exemple utiliser un substrat 30 en silicium et un miroir constitué d'une alternance de couches de tungstène et d'aluminium. Au-dessus du miroir acoustique est disposée une couche piézoélectrique 41, par exemple en nitrure d'aluminium, AlN, ou en oxyde de zinc, ZnO. Sur la couche piézoélectrique 41 sont disposés des moyens d'excitation en surface, par exemple deux peignes à dents entrelacées d'excitation 43 et deux peignes à dents entrelacées de réception 44 pour constituer une ligne à retard à ondes acoustiques similaire à celle décrite en relation avec la figure 1.

Les inventeurs ont montré que, avec une telle structure, si certaines conditions dimensionnelles et fréquentielles qui seront exposées ci-après sont respectées, les ondes qui se propagent dans la couche piézoélectrique 41 ne sont plus ni des ondes acoustiques de surface (SAW) ni des ondes acoustiques de volume (BAW) mais des ondes d'une nature particulière qui seront appelées ondes guidées. La vitesse de ces ondes guidées, qui se propagent dans le plan de la couche, peut être choisie très élevée, par exemple cinq à dix fois plus rapide que les ondes acoustiques de surface. De plus, ces ondes acoustiques guidées peuvent être excitées et reçues en surface par les mêmes systèmes de peignes conducteurs interdigités que des ondes acoustiques de surface classiques. On pourra donc réaliser les mêmes composants dans une structure selon la présente invention que ceux couramment utilisés en relation avec des ondes acoustiques de surface.

On voit immédiatement l'avantage d'un tel dispositif. Les ondes acoustiques se propageant n fois plus rapidement que les ondes acoustiques de surface classique, on pourra, pour un réseau d'excitation de pas donné, faire se propager des ondes à une fréquence n fois plus élevée. Ainsi, dans le cas où n=6, un dispositif excitateur ou récepteur couramment utilisé pour fonctionner à une fréquence donnée pourra fonctionner à une fréquence 6 fois plus élevée. Un système excitateur ou récepteur en surface adapté à une fréquence de l'ordre de 2 gigahertz pourra être utilisé pour des fréquences de 12 gigahertz sans modification du pas des dents de peignes interdigités.

Comme miroir acoustique, on pourra utiliser tout miroir connu à condition que l'ensemble qu'il forme avec le substrat présente une bande de fréquence interdite omnidirectionnelle.

Un mode de détermination d'un miroir omnidirectionnel va être décrit en relation avec la figure 4. Pour un multicouche donné, par exemple une alternance de couches d'aluminium et de couches de tungstène de mêmes épaisseurs, on calcule les courbes de dispersion illustrées en figure 4 (voir par exemple Phys. Rev. E66, 056609, 2002, D. Bria et B. Djafari-Rouhani). Ces courbes de dispersion indiquent, en hachures, toutes les régions dans lesquelles des modes de vibration peuvent exister dans la structure (miroir plus substrat) en fonction du rapport entre le pas D du multicouche et la longueur d'onde λ, le pas étant la somme des épaisseurs d'une couche de chaque matériau constituant le miroir. Les deux droites marquées VL et VT indiquent respectivement les vitesses transverse et longitudinale des ondes acoustiques dans le substrat (du silicium dans cet exemple). Les zones claires illustrent les régions dans lesquelles toute propagation est interdite. Dans le cas de la structure illustrée, on constate que, dans la plage de produit (fréquence)x(épaisseur) comprise entre 1,2 et 2,4 GHz.µm (par exemple, pour un pas D = 0,4 pm, la bande de fréquence interdite s'étend entre 3 et 6 GHz), aucun mode de propagation n'est possible quelle que soit la longueur d'onde. Dans cette plage, la structure réfléchit toutes les ondes de toutes les incidences : il s'agit d'un miroir acoustique omnidirectionnel. Il est important de noter que les fréquences limite des courbes de dispersion sont proportionnelles au pas D de la structure multicouche. Ainsi, une fois le réseau de courbes déterminé pour un certain pas de couches du miroir, on pourra choisir une bande interdite différente en augmentant de façon proportionnelle le pas des couches.

On devra ensuite choisir l'épaisseur de la couche piézoélectrique 41 pour qu'elle puisse vibrer dans la bande de fréquence concernée. En effet, quand on ajoute une couche au-dessus d'un miroir, on introduit des modes de défaut additionnels. Si certains se trouvent dans la bande interdite, ils sont nécessairement guidés dans la couche sans possibilité de fuir dans le substrat. Par exemple, pour une couche piézoélectrique de nitrure d'aluminium (AlN) d'une épaisseur de l'ordre de 800 nm, on obtient un mode de défaut dans la bande interdite. La fréquence de coupure de mode est de l'ordre de 4 GHz.

Pour un pas de peigne de 3,57 pm, la vitesse de propagation des ondes acoustiques parallèlement au plan de la surface du dispositif est de l'ordre de 30000 m/s. Cette vitesse est sept fois plus grande que la vitesse des ondes de surface usuelles dans des substrats de tantalate de lithium.

Les pertes de propagation sont sensiblement comparables à celles que l'on obtient pour les dispositifs à ondes de surface. En outre, le coefficient de couplage obtenu est de l'ordre de 3 %, soit sensiblement trente fois plus grand que celui que l'on obtient dans le cas d'une onde de surface avec un matériau d'AlN massif.

Bien que l'on ait indiqué l'AlN comme matériau préféré pour la couche piézoélectrique, tout autre matériau piézoélectrique couramment utilisé pourra être utilisé, par exemple le ZnO, le LiNbO₃, le KNbO₃...

Bien entendu, la présente invention est susceptible de diverses variantes et modifications qui apparaîtront à l'homme de l'art. En particulier, une ou plusieurs couches minces peuvent être ajoutées au-dessus du dispositif dans un but de passivation ou d'encapsulation. En outre, un deuxième miroir acoustique pourra être disposé au-dessus de la couche piézoélectrique dans un but de confinement de l'énergie acoustique dans cette couche piézoélectrique.

## Revendications

1. Dispositif à ondes acoustiques comprenant :
- un substrat (30), surmonté d'un miroir acoustique,
- un miroir acoustique (31) constitué d'un empilement d'un couple donné de matériaux, en couches alternées à haute et basse impédance acoustique,
- une couche piézoélectrique (41) disposée au-dessus du miroir acoustique, et
- des moyens d'excitation et/ou de réception (43, 44) constitués de peignes conducteurs interdigités sur une surface de ladite couche piézoélectrique,
**caractérisé en ce que** le dispositif à ondes acoustiques comprends additionnellement
le miroir acoustique (31) présentant un pas, correspondant à la somme des épaisseurs d'une couche de chaque matériau du couple donné de matériaux, configuré pour rendre le miroir acoustique omnidirectionnel, réfléchissant dans une plage de fréquence les ondes de toutes les incidences,
les moyens d'excitation et/ou de réception (43, 44) étant propres à exciter des ondes dans ladite plage de fréquence correspondant à une bande interdite du miroir acoustique où aucun mode de propagation n'est possible quelle que soit la longueur d'onde,
la couche piézoélectrique présentant une épaisseur de couche déterminée en fonction de ladite plage de fréquence dans laquelle ladite couche piézoélectrique est propre à vibrer en guidant les ondes acoustiques excitées par les moyens d'excitation et/ou de réception (43, 44).

2. Utilisation du dispositif selon la revendication 1, comme filtre.

3. Utilisation du dispositif selon la revendication 1, comme résonateur.

4. Utilisation du dispositif selon la revendication 1, comme ligne à retard.

5. Procédé de détermination d'un dispositif à ondes acoustiques comprenant
- un substrat (30), surmonté d'un miroir acoustique,
- un miroir acoustique (31) constitué d'un empilement d'un couple donné de matériaux, en couches alternées à haute et basse impédance acoustique,
- une couche piézoélectrique (41) disposée au-dessus du miroir acoustique, et des moyens d'excitation et/ou de réception (43, 44) constitués de peignes conducteurs interdigités sur une surface de ladite couche piézoélectrique,
**caractérisé en ce que** le procédé comprends les étapes suivantes:
pour le couple donné de matériaux constituant le miroir acoustique sur un substrat donné, calculer les courbes de dispersion et choisir la valeur de la somme des épaisseurs d'une couche de chaque matériau du couple donné de matériaux de sorte qu'un empilement du couple donné de matériaux constitue un miroir omnidirectionnel ayant une bande interdite dans une bande de fréquence souhaitée; et
choisir l'épaisseur de la couche piézoélectrique pour que le miroir reste omnidirectionnel et que la couche piézoélectrique ait un mode de vibrations acoustiques dans la plage de fréquences interdites du miroir.

## Patentansprüche

1. Akustische Wellenvorrichtung, umfassend:
- ein Substrat (30), das von einem akustischen Spiegel überlagert ist,
- einen akustischen Spiegel (31), der aus einem Stapel aus einem vorgegebenen Materialpaar, in abwechselnden Schichten mit hoher und niedriger akustischer Impedanz, besteht,
- eine piezoelektrische Schicht (41), die über dem akustischen Spiegel angeordnet ist, und
- Anregungs- und/oder Empfangsmittel (43, 44), bestehend aus ineinandergreifenden leitenden Kämmen auf einer Oberfläche der piezoelektrischen Schicht,
**dadurch gekennzeichnet, dass** die akustische Wellenvorrichtung zusätzlich umfasst:
den akustischen Spiegel (31), der eine Neigung, die der Summe der Dicken einer Schicht aus jedem Material des vorgegebenen Materialpaares entspricht, der eingerichtet ist, um den akustischen Spiegel omnidirektional zu machen, und der in einem Frequenzbereich die Wellen aller Inzidenzen reflektiert,
wobei die Anregungs- und/oder Empfangsmittel (43, 44) geeignet sind, Wellen in dem Frequenzbereich anzuregen, der einer Bandlücke des akustischen Spiegels entspricht, bei der kein Ausbreitungsmodus unabhängig von der Wellenlänge möglich ist,
wobei die piezoelektrische Schicht eine Schichtdicke aufweist, die entsprechend dem Frequenzbereich bestimmt ist, in dem die piezoelektrische Schicht geeignet ist, durch Leiten der durch die Anregungs- und/oder Empfangsmittel (43, 44) angeregten akustischen Wellen zu schwingen.

2. Verwendung der Vorrichtung nach Anspruch 1 als Filter.

3. Verwendung der Vorrichtung nach Anspruch 1 als Resonator.

4. Verwendung der Vorrichtung nach Anspruch 1 als Verzögerungsleitung.

5. Verfahren zum Bestimmen einer akustischen Wellenvorrichtung, umfassend
- ein Substrat (30), das von einem akustischen Spiegel überlagert ist,
- einen akustischen Spiegel (31), der aus einem Stapel aus einem vorgegebenen Materialpaar besteht, in abwechselnden Schichten mit hoher und niedriger akustischer Impedanz,
- eine piezoelektrische Schicht (41), die über dem akustischen Spiegel angeordnet ist, und Anregungs- und/oder Empfangsmittel (43, 44), die aus ineinandergreifenden leitenden Kämmen auf einer Oberfläche der piezoelektrischen Schicht bestehen,
**dadurch gekennzeichnet, dass** das Verfahren die folgenden Schritte umfasst:
für das vorgegebene Materialpaar, das den akustischen Spiegel auf einem vorgegebenen Substrat bildet, Berechnen der Dispersionskurven und Auswählen des Wertes der Summe der Dicken einer Schicht aus jedem Material des vorgegebenen Materialpaares, so dass ein Stapel aus dem vorgegebenen Materialpaar einen omnidirektionalen Spiegel bildet, der eine Bandlücke in einem gewünschten Frequenzband aufweist; und
Wählen der Dicke der piezoelektrischen Schicht derart, dass der Spiegel omnidirektional bleibt und die piezoelektrische Schicht einen akustischen Vibrationsmodus im Bereich der Frequenzlücke des Spiegels aufweist.

## Claims

1. Acoustic wave device comprising:
- a substrate (30) surmounted with an acoustic mirror,
- an acoustic mirror (31) constituted by a stack of a given pair of materials in alternate layers with high and low acoustic impedance,
- a piezoelectric layer (41) arranged above the acoustic mirror, and
- excitation and/or receiving means (43, 44) constituted by interdigitated conductor combs on a surface of said piezoelectric layer,
**characterised in that** the acoustic wave device additionally comprises
the acoustic mirror (31) having a pitch, corresponding to the sum of the thicknesses of a layer of each material of the given pair of materials, which is configured to render the acoustic mirror omnidirectional, reflecting in a frequency range the waves of all incidences,
the excitation and/or receiving means (43, 44) being capable of exciting waves in said frequency range corresponding to a band gap of the acoustic mirror where no propagation mode is possible whatever the wavelength,
the piezoelectric layer having a layer thickness determined as a function of said frequency range in which said piezoelectric layer is capable of vibrating while guiding the acoustic waves excited by the excitation and/or receiving means (43, 44).

2. Use of the device according to claim 1, as a filter.

3. Use of the device according to claim 1, as a resonator.

4. Use of the device according to claim 1, as a delay line.

5. Method for determining an acoustic wave device comprising
- a substrate (30) surmounted with an acoustic mirror,
- an acoustic mirror (31) constituted by a stack of a given pair of materials in alternate layers with high and low acoustic impedance,
- a piezoelectric layer (41) arranged above the acoustic mirror, and
- excitation and/or receiving means (43, 44) constituted by interdigitated conductor combs on a surface of said piezoelectric layer,
**characterised in that** the method comprises the following steps:
for the given pair of materials constituting the acoustic mirror on a given substrate, calculating the dispersion curves and choosing the value of the sum of the thicknesses of a layer of each material of the given pair of materials such that a stack of the given pair of materials constitutes an omnidirectional mirror having a band gap in a desired frequency band; and
choosing the thickness of the piezoelectric layer such that the mirror remains omnidirectional and the piezoelectric layer has an acoustic vibration mode in the prohibited frequency range of the mirror.
